**Europäisches Patentamt**

**European Patent Office**

**Office européen des brevets**

(11) Veröffentlichungsnummer : **0 172 803**
**B1**

(12) **EUROPÄISCHE PATENTSCHRIFT**

(45) Veröffentlichungstag der Patentschrift :
04.05.88

(21) Anmeldenummer : 85890134.1

(22) Anmeldetag : 24.06.85

(51) Int. Cl.⁴ : **G 01 B 21/00**

(54) Verfahren zur digitalen elektrischen Längen- oder Winkelmessung und Schaltungsanordnung zur Durchführung dieses Verfahrens.

(30) Priorität : 03.07.84 AT 2139/84

(43) Veröffentlichungstag der Anmeldung :
26.02.86 Patentblatt 86/09

(45) Bekanntmachung des Hinweises auf die Patenterteilung : 04.05.88 Patentblatt 88/18

(84) Benannte Vertragsstaaten :
BE CH DE FR GB IT LI LU NL SE

(56) Entgegenhaltungen :
DE-A- 2 729 697
DE-A- 3 036 830
DE-C- 1 638 032
US-A- 3 618 073

(73) Patentinhaber : RSF-Elektronik Gesellschaft m.b.H.

A-5121 Tarsdorf 93 (AT)

(72) Erfinder : Rieder, Heinz
Riedersbach 90
A-5120 St. Pantaleon (AT)
Erfinder : Schwaiger, Max

A-5121 Ostermiething 298 (AT)

(74) Vertreter : Hübscher, Gerhard, Dipl.-Ing. et al
Patentanwälte Dipl.-Ing. Gerhard Hübscher Dipl.-Ing.
Helmut Hübscher Dipl.-Ing. Heiner Hübscher Spittelwiese 7
A-4020 Linz (AT)

## Beschreibung

Die Erfindung betrifft ein Verfahren zur digitalen elektrischen Längen- oder Winkelmessung, bei dem durch Abtastung eines Maßstabes mit periodisch wiederholter Teilung, insbesondere eines Inkrementalmaßstabes, gewonnene Signale einer Interpolationseinrichtung zur Gewinnung von Zwischenwerten zugeführt und aus den Zwischenwerten und den Maßstabteilstücken adressenrichtig zugeordnet gespeicherten Korrekturwerten Meßwerte errechnet und entsprechende Signale einer Anzeige- bzw. Steuereinheit zugeführt werden.

Die Erfindung betrifft auch ein Verfahren zur Bestimmung der Korrekturwerte, wobei die Meßbereichslänge oder der Winkelmeßbereich einerseits mittels der Meßeinrichtung unter Abtastung des Maßstabes abgefahren, anderseits parallel dazu mit einem übergeordneten Meßsystem ausgemessen wird und Abweichungen der Meßergebnisse in Korrekturspeichern festgelegt werden.

Schließlich betrifft die Erfindung noch eine Schaltungsanordnung zur Durchführung des Verfahrens zur Korrekturwertbestimmung, mit einer Meßeinrichtung für einen Meßbereich, die eine Abtasteinheit für einen über den Meßbereich reichenden Maßstab sowie eine Signalauswerteeinheit mit Interpolationsrechner, Meßwertrechner und Signalgenerator für eine Anzeige- bzw. Steuereinheit aufweist, wobei dem Meßwertrechner ein Korrekturspeicher zugeordnet ist, und einem übergeordneten Meßsystem zur Kontrollausmessung des Meßbereiches und einer Vergleicherstufe zur Bestimmung von speicherbaren Korrekturwerten aus Abweichungen des momentanen Meßwertes der Meßeinrichtung vom Meßwert des übergeordneten Meßsystems.

Verfahren der eingangs genannten Art und auch eine entsprechende Schaltungsanordnung sind dem Prinzip nach aus der DE-A-3 036 830 bekannt, die ihrerseits auf den Lehren der DE-C-1 638 032 und der DE-A-2 729 697 aufbaut. Die Verwendung einer Interpolationseinrichtung, nämlich eines Interpolationsrechners, zur Bestimmung von Zwischenwerten ist aus der US-A-3 618 073 bekannt.

Prinzipiell sind Verfahren der eingangs genannten Art bei der Längen- und Winkelmessung mit Maßstäben mit Inkrementalteilung, mit Inkrementalteilung mit Referenzmarken und auch bei Maßstäben mit codierter absoluter Teilung anwendbar, wobei im letzteren Fall bei genaueren Maßstäben fast ausschließlich die feinste Teilungsspur eine Inkrementalspur ist.

Durch Verwendung eines Interpolationsrechners ist es theoretisch möglich, die einzelnen Signalperioden, die beispielsweise Maßstabinkrementen entsprechen, rechnerisch beliebig zu unterteilen, also die gewünschte Auflösung bei der Anzeige oder Auswertung unabhängig von der Größe der Teilungsinkremente zu erzielen. In der Praxis ist es durchaus üblich, die periodischen Abtastsignale, die von Inkrementalmaßstäben erhalten werden, rechnerisch größenordnungsmäßig im Bereich von 1 : 100 aufzulösen. Dazu werden Interpolationstabellen erstellt und gespeichert und die jeweilige Adresse dieser Interpolationstabelle wird auf Grund der momentanen Signalgröße des Abtastsignals — das gegebenenfalls vorher einer Umformung und Korrektur unterzogen wurde, angesprochen, so daß der gespeicherte Wert als Interpolationswert der weiteren Berechnung bzw. Anzeige oder Auswertung zugrundegelegt wird. Es ist dabei meist üblich, die vollen Signalperioden über Zähleinrichtungen zu erfassen und bei reinen Inkrementalmaßstäben auch die Verstellrichtung aus den Analogsignalen zu bestimmen. Bei Absolutsystemen mit feinster Inkrementalspur werden im Rechner oder in einer nachgeordneten Einrichtung die Absolutwerte mit den errechneten Interpolationswerten verknüpft.

Eine hohe Auflösung bei der Anzeige bzw. Auswertung, beispielsweise in Maschinensteuerungen, Automaten usw., ist nur dann sinnvoll, wenn die mögliche Anzeigegenauigkeit sich in der Größenordnung nicht zu stark von der tatsächlich erzielbaren Meßgenauigkeit unterscheidet.

Die erzielbare Meßgenauigkeit ihrerseits hängt u. a. von der Genauigkeit des Maßstabes, von der Übereinstimmung von Maßstabverlauf und Meßrichtung, von der Abtastgenauigkeit, von der Einhaltung des richtigen Phasenabstandes bei erzeugten, phasenversetzten Signalen, von der Einhaltung einer bestimmten Signalform und -größe und auch von äußeren Faktoren, beispielsweise von Maschinenfehlern der Werkzeugmaschinen ab, auf denen Längen- oder Winkelmeßeinrichtung der gegenständlichen Art eingesetzt werden.

Zum Ausgleich dieser möglichen Fehler und zur Erzielung einer möglichst hohen Meßgenauigkeit werden bei den bisher üblichen Meßverfahren der eingangs genannten Art die die Interpolationseinrichtung verlassenden Signale im Korrekturrechner zusätzlich mit vorab gespeicherten Korrekturwerten beaufschlagt und so berichtigt. Das Verfahren ist in seiner bisherigen Art zwar brauchbar, insgesamt gesehen aber äußerst aufwendig. Es ist nämlich üblich, zu jedem möglichen Interpolationswert der gesamten Meßstrecke je einen Korrekturwert zu speichern, wobei diese Korrekturwerte selbstverständlich untereinander verschiedene Absolutgrößen aufweisen können, welche Absolutgrößen in entsprechenden Speicherwerten festzuhalten sind. Dies bedeutet, daß an jeder Speicheradresse verschiedene Speicherwerte festgehalten werden müssen. Es ergeben sich dadurch für die Durchführung des Verfahrens sehr große und dabei aufwendige Speicher. Da bei systematischen Teilungsfehlern (Istanzahl der Inkremente über die Meßlänge weicht von der Sollanzahl ab), in bestimmten Bereichen der Meßlänge sehr hohe Korrekturwerte auftreten würden,

ist es auch bekannt, den systematischen Teilungsfehler abschnittsweise zu erfassen und für jeden Maßstababschnitt einen Korrekturfaktor zu speichern, der dem mittleren Verlauf der systematischen Teilungsfehlers entspricht und bei der Korrekturberechnung der Meßwerte berücksichtigt wird. Ferner wird zur Verringerung der erforderlichen Speicherkapazität für Maßstababschnitte, in denen man etwa einen gleichartigen Fehlerverlauf annehmen kann, ein mittlerer Fehlerverlauf über die Periode festgelegt, d. h. angenommen und im Korrekturspeicher durch entsprechende Korrekturwerte berücksichtigt. Es wird dadurch zwar die Speicherkapazität verringert, die Genauigkeit der Korrektur aber wesentlich beeinträchtigt. Insbesondere können durch Maschinenfehler bedingte Meßfehler auf diese Weise kaum kompensiert werden.

Aufgabe der Erfindung ist es, ein Verfahren der eingangs genannten Art zur digitalen elektrischen Längen- oder Winkelmessung zu verbessern und dabei bei Vereinfachung der notwendigen Einrichtungen die tatsächliche Meßgenauigkeit zu erhöhen. Eine weitere Aufgabe der Erfindung besteht in der Schaffung eines geeigneten Verfahrens zur Bestimmung der Korrekturwerte und einer dafür passenden Schaltungsanordnung.

Bei einem Verfahren zur digitalen elektrischen Längen- oder Winkelmessung der genannten Art besteht die Erfindung im wesentlichen darin, daß für die Korrektur lediglich Korrekturadressen und die Vorzeichen für die Korrektur gespeichert und den Korrekturadressen für gleiche Vorzeichen gleich große Einzelkorrekturwerte zugeordnet werden und daß bei der Meßwerterrechnung der dem jeweiligen Meßpunkt zugeordnete momentane Korrekturwert aus der Anzahl der für den bei der Messung erfaßten Maßstabbereich gespeicherten Einzelkorrekturwerte vorzeichenrichtig errechnet wird, wobei gegebenenfalls ein Interpolationswert zu einer auf den erfaßten Maßstabbereich folgenden Korrekturadresse berücksichtigt wird.

Der entscheidende Vorteil des erfindungsgemäßen Verfahrens besteht darin, daß mit einer einfachen Adressenspeicherung gearbeitet werden kann und der momentane Korrekturwert mit dem ein Interpolationswert beaufschlagt werden muß, mit Hilfe des ohnehin benötigten Meßwertrechners errechnet werden kann. Im einfachsten Fall ergibt sich der momentane Korrekturwert aus der vorzeichenrichtigen Summe der Anzahl der angesprochenen Adressen bis zum festgelegten oder gewählten Maßstabpunkt mal dem gewählten Festwert. Dabei kann aus der Verteilung der angesprochenen Adressen über die Maßstablänge zusätzlich ein Korrekturprofil errechnet werden, und es sind interpolierte Korrekturwerte in zwischen zwei angesprochenen Adressen liegenden Maßstabbereichen möglich. Beispielsweise kann man den festen Korrekturwert so wählen, daß er einem Zehntel der Anzeigegenauigkeit des Meßsystems entspricht. In den meisten Fällen wird es ausreichen, wenn nur jedem Maßstabinkrement (und nicht jedem interpolierbaren Zwischenwert) eine Speicheradresse zugeordnet wird. Trotzdem können sowohl systematische Teilungsfehler als auch die anderen Fehler korrigiert werden.

Da eine vorzeichenrichtige Speicherung notwendig ist, kann man die verschiedenen Vorzeichen zugeordneten Adressen in verschiedenen Speichern festhalten.

Bei dem erfindungsgemäßen Verfahren zur Bestimmung der Korrekturwerte wird ein Fehlertoleranzwert als Festwert vorgewählt, und es werden die jenen Maßstabstellen zugeordneten Speicheradressen vorzeichenrichtig aufgesucht, bei denen der Meßwert des übergeordneten Meßsystems vom momentanen Meßwert der Meßeinrichtung bzw. vom bis zum zuletzt aufgetretenen Einzelkorrekturwert errechneten, durch das Produkt aus der vorzeichenrichtigen Summe der bereits gespeicherten Adressen und dem Festwert korrigierten Meßwert um den Festwert nach oben oder unten abweicht.

Dabei kann man die Speicheradressen zunächst in einem Arbeitsspeicher des übergeordneten Meßsystems festhalten und dann in einen Festwertspeicher der Meßeinrichtung überschreiben.

Besonders bei der Anwendung des Verfahrens auf Werkzeugmaschinen und Robotern kann der sich ergebende, verstellrichtungsabhängige Meßfehler dadurch berücksichtigt werden, daß der Meßbereich nacheinander in beiden Verstellrichtungen abgefahren und die Korrekturwerte verstellrichtungsabhängig gespeichert und abgefragt werden. Es ist sogar möglich, eine eigene Korrekturspeicherung bei der Belastung vorzunehmen, wenn beispielsweise auf Robotern fortlaufend die gleichen Werkstücke gefertigt werden, so daß eine Messung bei der gleichen Belastung entsprechend korrigiert werden kann.

Eine Schaltungsanordnung der eingangs genannten Art zur Durchführung des Verfahrens zur Bestimmung der Korrekturwerte zeichnet sich dadurch aus, daß die Vergleicherstufe als auf einen Festwert eingestellter Meßwertkomparator ausgebildet ist, der bei der Abtastung des Maßstabes unter Einbeziehung eines Korrekturrechners jeweils jenen Maßstabstellen zugeordnete Adressen des Korrekturspeichers bzw. eines Arbeitsspeichers des übergeordneten Meßsystems auswählt, in deren Bereich der momentane Meßwert der Meßeinrichtung bzw. der bis zur zuletzt aufgetretenen Korrektur berichtigte Meßwert vom Meßwert des übergeordneten Meßsystems abweicht, wobei bei Verwendung eines Arbeitsspeichers im übergeordneten Meßsystem die Korrekturadressen in den Korrekturspeicher der Meßeinrichtung überschreitbar sind.

Weitere Einzelheiten und Vorteile des Erfindungsgegenstandes entnimmt man der Zeichnungsbeschreibung.

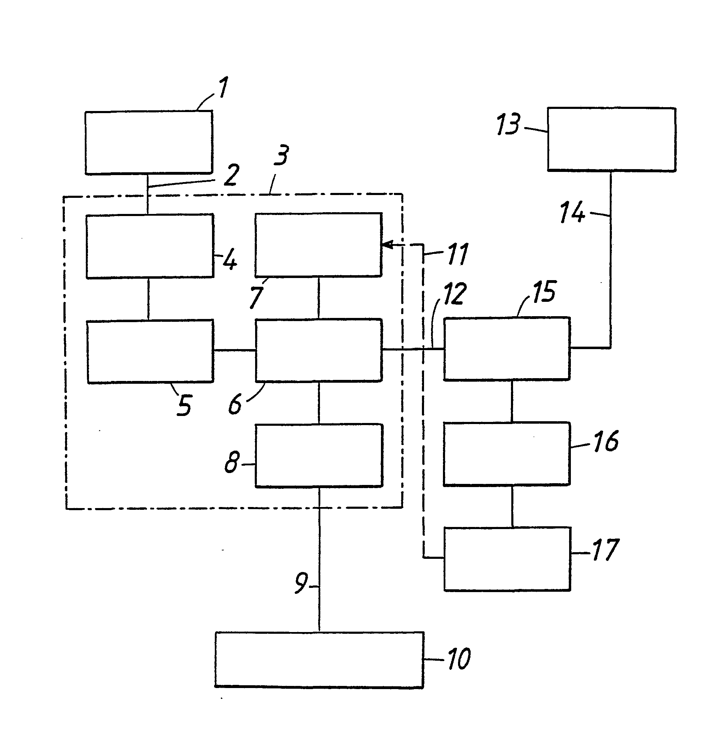

In der Zeichnung ist als Ausführungsbeispiel eine erfindungsgemäße Schaltungsanordnung zur Bestimmung der Korrekturwerte im Zusammenhang mit einer inkrementalen Meßeinrichtung im Blockschaltschema veranschaulicht.

Eine inkrementale Meßeinrichtung, die als Längen- oder Winkelmeßeinrichtung ausgebildet sein kann, besitzt eine Abtasteinheit 1 für einen gegebenenfalls codierten oder mit Referenzmarken versehenen Inkrementalmaßstab, der ein Längenmaßstab oder ein Winkelmaßstab (Drehgeberscheibe) sein kann. Der Inkrementalmaßstab kann als optisch ablesbarer Maßstab in Form einer Strichteilung ausgeführt, aber auch nach induktiven magnetischen oder kapazitiven Abtastprinzipien abtastbar sein. In den meisten Fällen werden — bei optoelektronischer Abtastung durch um Bruchteile der Inkrementalteilung versetzte Ablesegitter und zugeordnete, durch Maßstab und Ablesegitter hindurch beleuchtete lichtempfindliche Elemente, z. B. Fototransistoren — wenigstens zwei gegeneinander phasenverschobene, in ihrer Grundform sinusförmige analoge Abtastsignale erzeugt, bei denen die Periodenlänge der abgetasteten Inkrementalteilung entspricht. Diese Signale werden über Leitungen 2 einer Auswerteeinheit 3 zugeführt. Diese Auswerteeinheit 3 besitzt einen Analogteil 4, in dem die Signale geformt und korrigiert werden können, wobei unter Korrektur eine Befreiung von Gleichspannungsanteilen und die Einstellung auf gleiche Signalhöhe und gleichbleibenden Phasenabstand verstanden werden kann. Entsprechende Korrekturen sind auch im Digitalteil, der später beschrieben werden wird, durchführbar. Ferner besitzt der Analogteil 4 eine Richtungserkennungsstufe, in der die relative Verstellrichtung der Abtasteinheit gegenüber dem jeweiligen Maßstab daraus festgestellt wird, welches der beiden Signale dem anderen voreilt. Die gegebenenfalls normierten Signale und die Informationen über die momentane Verstellrichtung werden über Mehrfachleitungen dem Digitalteil der Auswerteeinheit 3 zugeführt. Zusätzlich kann dem Analogteil 4 auch eine Zähleinrichtung zugeordnet sein, die die Anzahl der zurückgelegten vollen Signalperioden und damit die Anzahl der Inkremente von einem Referenzpunkt oder einem gewählten Nullpunkt zählt. Auch diese Signale werden dem Digitalteil zugeführt. Die Analogsignale werden über einen A/D-Wandler digitalisiert.

Die Digitalsignale werden einem Interpolationsrechner 5 zugeleitet, der über die Länge der jeweiligen Signalperioden Interpolationsberechnungen durchführt und — meist unter Verwendung eines Interpolationsspeichers — aus anstehenden Signalwerten Interpolationswerte errechnet, also die Inkrementalteilung rechnerisch unter Ausnützung der Abtastsignale unterteilt. Die Ergebnisse der Interpolationsberechnung werden einem Meßwertrechner 6 zugeführt, der vorzugsweise auch gleich mit den vom Analogteil 4 kommenden Zählsignalen beaufschlagt wird und aus den Zählsignalen und den Interpolationswerten einen Meßwert errechnet. Für diese Meßwertberechnung werden dem Meßwertrechner zusätzlich von einem Korrekturspeicher 7 Korrekturwerte zugeführt. Beim Ausführungsbeispiel sind im Korrekturspeicher lediglich jenen Maßstabinkrementen bzw. Inkrementbruchteilen zugeordnete Adressen gespeichert, an denen eine Korrektur um einen bestimmten Betrag vorzunehmen ist.

Ferner ist festgehalten, mit welchem Vorzeichen der Festbetrag an der jeweiligen Adresse Gültigkeit hat. Der Meßwertrechner hat vom Längenmeßsystem her und über die Interpolationsberechnung bzw. die Zähleinrichtung darüber Informationen zur Verfügung, an welcher Stelle des Maßstabes sich die Abtasteinheit momentan befindet. Ferner erhält der Meßwertzähler aus dem Speicher 7 Informationen über Anzahl und Vorzeichen der angesprochenen Adressen zwischen einem Maßstabfestpunkt und dem Abtastpunkt sowie gegebenenfalls Informationen über Abstand und Vorzeichen der in Abtastrichtung folgenden, anzuwählenden Adressen. Aus diesen Informationen führt der Rechner 6 eine Korrekturwertberechnung durch und beaufschlagt die ihm zugeordneten Meßinformationen entsprechend, so daß die Ausgangssignale des Meßwertrechners entsprechend dem zu berücksichtigenden Speicherwert korrigiert sind. Der Meßwertrechner 6 steuert einen Signalgenerator 8, dessen Ausgangssignale über eine Leitung 9 einer Anzeige- oder Steuereinheit 10 zugeführt bzw. zu deren Steuerung verwendet werden.

Zur Festlegung der Adressen im Korrekturspeicher 7 besitzt dieser Korrekturspeicher einen Einschreibeeingang 11, und der Meßwertrechner 6 ist mit einem zusätzlichen Ausgang 12 versehen. An der Meßstrecke wird ein übergeordnetes Meßsystem 13 installiert, mit dem der Meßbereich parallel zum bestehenden Meßsystem ausgemessen wird.

Bei der Längenmessung wird vorzugsweise an der Meßstrecke ein Laser-Interferometer installiert. Der Meßwertausgang 14 des Interferometers 13 und der Ausgang 12 des Meßwertrechners liegen an einem Meßwertkomparator 15, der auf einen vorgewählten Schwellwert — beispielsweise einen 10 % der höchsten Interpolationsauflösung betragenden Festwert — eingestellt ist. Die Meßstrecke wird abgefahren und dabei gleichzeitig mit der die Abtasteinheit 1 aufweisenden Längenmeßeinrichtung und mit dem Interferometer 13 ausgemessen. Treten Fehler auf, die den Schwellwert übersteigen, so gibt der Meßwertkomparator 15 ein Signal ab, das über einen Korrekturrechner 16 an einer jener Stelle des Maßstabes, an dem das Fehlersignal aufgetreten ist, zugeordneten Adresse eines Korrekturspeichers 17 gespeichert wird. Im Speicher wird lediglich festgelegt, daß an dieser Adresse eine Speicherung stattgefunden hat, wobei auch das Vorzeichen — beispielsweise durch Verwendung getrennter Speichereinheiten für die beiden Vorzeichen — berücksichtigt wird. Nach einmaligem Abfahren der Meßstrecke sind somit im Korrekturspeicher 17 die Korrekturadressen festgehalten. Man kann eine weitere Speicherung von Korrekturadressen in der anderen Verstellrichtung des Meßsystems bzw. bei der Betriebsbelastung einer mit dem Meßsystem ausgestatteten Maschine oder eines Roboters vornehmen. Die bereits durch Adressen festgehaltenen Korrekturstellen und die daraus resultierenden Korrekturen werden im Meßwertrechner 6 oder im Korrekturrechner 16 berücksichtigt, so daß am Meßwertkomparator jeweils ein Vergleich des bis auf die letzte Adressenspeicherung korrigierten Meßwertes vom Meßwertrechner 6 mit dem Meßwert des Laserinterferometers 13 stattfindet. Der Inhalt des Speichers 17 wird schließlich in den Korrekturspeicher 7 überschrieben. Nach einer Ausführungsvariante könnte der Korrekturrechner 16 unmittelbar den Korrekturspeicher 17 ansprechen. Dies würde aber einen aufwendigeren Speicher im Meßsystem 3 voraussetzen.

**Patentansprüche**

1. Verfahren zur digitalen elektrischen Längen- oder Winkelmessung, bei dem durch Abtastung eines Maßstabes, insbesondere eines Inkrementalmaßstabes, gewonnene Signale einer Interpolationseinrichtung (5) zur Gewinnung von Zwischenwerten zugeführt und aus den Zwischenwerten und den Maßstabteilstücken adressenrichtig zugeordnet gespeicherten Korrekturwerten Meßwerte errechnet und entsprechende Signale einer Anzeige- bzw. Steuereinheit (10) zugeführt werden, dadurch gekennzeichnet, daß für die Korrektur lediglich Korrekturadressen und die Vorzeichen für die Korrektur gespeichert und den Korrekturadressen für gleiche Vorzeichen gleich große Einzelkorrekturwerte zugeordnet werden und daß bei der Meßwerterrechnung der dem jeweiligen Meßpunkt zugeordnete momentane Korrekturwert aus der Anzahl der für den bei der Messung erfaßten Maßstabbereich gespeicherten Einzelkorrekturwerte vorzeichenrichtig errechnet wird, wobei gegebenenfalls ein Interpolationswert zu einer auf den erfaßten Maßstabbereich folgenden Korrekturadresse berücksichtigt wird.

2. Verfahren nach Anspruch 1, dadurch gekennzeichnet, daß die verschiedenen Vorzeichen zugeordneten Adressen in verschiedenen Speichern (7) festgehalten werden.

3. Verfahren zur Bestimmung der Korrekturwerte für das Verfahren nach einem der Ansprüche 1 und 2, wobei die Meßbereichslänge oder der Winkelmeßbereich einerseits mittels der Meßeinrichtung (1) unter Abtastung des Maßstabes abgefahren, anderseits parallel dazu mit einem übergeordneten Meßsystem (13) ausgemessen wird und Abweichungen der Meßergebnisse in Korrekturspeichern (7, 17) festgelegt werden, dadurch gekennzeichnet, daß ein Fehlertoleranzwert als Festwert vorgewählt und die jenen Maßstabstellen zugeordneten Speicheradressen vorzeichenrichtig aufgesucht werden, bei denen der Meßwert des übergeordneten Meßsystems (13) vom momentanen Meßwert der Meßeinrichtung (1) bzw. vom bis zum zuletzt aufgetretenen Einzelkorrekturwert errechneten, durch das Produkt aus der vorzeichenrichtigen Summe der bereits gespeicherten Adressen und dem Festwert korrigierten Meßwert um den Festwert nach oben oder unten abweicht.

4. Verfahren nach Anspruch 3, dadurch gekennzeichnet, daß die Speicheradressen zunächst in einem Arbeitsspeicher (17) des übergeordneten Meßsystems (13) festgehalten und dann in einen Festwertspeicher (7) der Meßeinrichtung (1) überschrieben werden.

5. Verfahren nach Anspruch 3 oder 4, dadurch gekennzeichnet, daß der Meßbereich nacheinander in beiden Verstellrichtungen abgefahren wird und die Korrekturwerte verstellrichtungsabhängig gespeichert und abgefragt werden.

6. Schaltungsanordnung zur Durchführung des Verfahrens nach einem der Ansprüche 3-5, mit einer Meßeinrichtung (1) für einen Meßbereich, die eine Abtasteinheit für einen über den Meßbereich reichenden Maßstab sowie eine Signalauswerteinheit mit Interpolationsrechner (5), Meßwertrechner (6) und Signalgenerator (8) für eine Anzeige- bzw. Steuereinheit (10) aufweist, wobei dem Meßwertrechner (6) ein Korrekturspeicher (7) zugeordnet ist, einem übergeordneten Meßsystem (13) zur Kontrollausmessung des Meßbereiches und einer Vergleicherstufe (15) zur Bestimmung von speicherbaren Korrekturwerten aus Abweichungen des momentanen Meßwertes der Meßeinrichtung (1) vom Meßwert des übergeordneten Meßsystems (13), dadurch gekennzeichnet, daß die Vergleicherstufe als auf einen Festwert eingestellter Meßwertkomparator (15) ausgebildet ist, der bei der Abtastung des Maßstabes unter Einbeziehung eines Korrekturrechners (16) jeweils jenen Maßstabstellen zugeordnete Adressen des Korrekturspeichers (7) bzw. eines Arbeitsspeichers (17) des übergeordneten Meßsystems (13) auswählt, in deren Bereich der momentane Meßwert der Meßeinrichtung (1) bzw. der bis zur zuletzt aufgetretenen Korrektur berichtigte Meßwert vom Meßwert des übergeordneten Meßsystems (13) um den Festwert abweicht, wobei bei Verwendung eines Arbeitsspeichers (17) im übergeordneten Meßsystem (13) die Korrekturadressen in den Korrekturspeicher (7) der Meßeinrichtung (1) überschreibbar sind.

**Claims**

1. A method of digital electrical linear or angular measurement in which signals obtained by scanning of a scale, more particularly an incremental scale, are supplied to an interpolation device (5) to obtain intermediate values, measured values are calculated therefrom and from the correction values stored in correct address association with the scale parts and corresponding signals are supplied to a display or control unit (10), characterised in that only correction addresses and the signs for the correction are stored for correction and correction addresses are, if like sign have associated with them individual correction values which are the same magnitude, and in the calculation of the measured value the instantaneous correction value associated with the particular measurement point under consideration is calculated with the correct sign from the number of individual correction values stored for the scale range covered in the measurement, possibly with consideration of an interpolation value for a correction address following the scale range covered.

2. A method according to claim 1, characterised in that the addresses associated with different signs are retained in different stores (7).

3. A method of determining the correction values for the method according to claim 1 and/or 2, the measurement range length or the angular measurement range being travelled over by means of the measuring facility (1) with scanning of the scale and being measured out in parallel with a superior measuring system (13), variations of the measurement results being determined in correction memories (7, 17), characterised in that an error tolerance value is preselected as fixed value and a search is made with the correct sign for the memory addresses associated with those places on the scale at which the measured value of the superior measurement system (13) varies by the fixed value above or below the instantaneous measured value of the measuring system (1) or from the measured value calculated from the most recent individual correction curve and corrected by the product of the correct-sign sum of the previously stored addresses and by the fixed value.

4. A method according to claim 3, characterised in that memory addresses are first retained in a work memory (17) of the superior measuring system (13), then transferred to a fixed value memory (7) of the measuring system (1).

5. A method according to claim 3 or 4, characterised in that the measurement range is travelled over consecutively in both directions of movement and the correction values are memorized and sampled in dependence upon the direction of travel.

6. A circuit arrangement for performing the method according to any of claims 3-5 and comprising a measuring system (1) for a measuring range, such system having a scanning unit, for a scale extending over the measurement range, a signal evaluation unit having an interpolation computer (5), a measured value computer (6), and a signal generator (8) for a display or control unit (10), there being associated with the measured value computer (6) a correction memory (7), the circuit arrangement also comprising a superior measurement system (13) for a check measurement of the measurement range, and a comparison stage (15) for determining storable correction values from variations of the instantaneous measured value of the system (1) from the measured value of the superior system (13), characterised in that the comparison stage is a measured value comparator (15) which is adjusted to a fixed value and which, when scanning the scale with the inclusion of a correction computer (16), selects addresses of the correction memory (7) or of a work memory (7) associated with those places on the scale near which the instantaneous measured value of the measuring system (1), or the measured value corrected up to the most recent correction, deviates by the fixed value from the measurement value of the superior measurement system (13) the correction addresses being transcribable into the correction memory (7) of the measuring system (1) when a work memory (17) is used in the superior measuring system (13).

**Revendications**

1. Procédé pour la mesure électrique numérique des longueurs ou des angles, dans lequel des signaux obtenus par l'exploration d'une échelle graduée, en particulier, d'une échelle graduée incrémentale, sont envoyés à un dispositif d'interpolation (5) pour former des valeurs intermédiaires et dans lequel des valeurs de mesure sont calculées à partir des valeurs intermédiaires et de valeurs correctives mémorisées et associées aux parties de l'échelle graduée par leurs adresses et des signaux correspondants sont envoyés à une unité d'affichage ou de commande (10), caractérisé par le fait que, pour la correction, on mémorise exclusivement des adresses de correction et les signes de la correction, et qu'on associe aux adresses de correction, pour les mêmes signes, des valeurs correctives individuelles de même grandeur et que, lors du calcul de la valeur mesurée, la valeur corrective instantanée associée au point de mesure considéré est calculée avec le bon signe, choisie dans le nombre valeurs correctives individuelles mémorisées pour la région de l'échelle graduée qui a été considérée lors de la mesure, et que l'on fait éventuellement intervenir une valeur d'interpolation pour une adresse de correction qui fait une suite à la région considérée de l'échelle graduée.

2. Procédé selon la revendication 1, caractérisé par le fait que les adresses associées aux différents signes sont mémorisées dans des mémoires (7) différentes.

3. Procédé pour déterminer les valeurs correctives pour le procédé selon l'une des revendications 1 et 2, dans lequel la longueur de la zone de mesure ou la zone de mesure angulaire est, d'une part, parcourue au moyen du dispositif de mesure (1), en explorant l'échelle graduée et, d'autre part, en parallèle avec cette action, mesurée avec un système de mesure supérieur (13) et les écarts des résultats des mesures étant alors mémorisés dans des mémoires de correction (7, 17), caractérisé par le fait qu'on pré-sélectionne comme valeur fixe une valeur de tolérance d'erreur et qu'on recherche, avec le signe, les adresses des mémoires associées aux zones de l'échelle graduée dans lesquelles la valeur de mesure du système de mesure supérieur (13) s'écarte, vers le haut ou vers le bas, d'une valeur égale à la valeur fixe de la valeur de mesure instantanée du dispositif de mesure (1), ou de la valeur de mesure calculée jusqu'à la valeur corrective individuelle entrée en dernier lieu, corrigée par le produit de la somme, munie de son bon signe, des adresses déjà mémorisées, par la valeur fixe.

4. Procédé selon la revendication 3, caractérisé par le fait que les adresses de mémoire sont tout d'abord mémorisées dans une mémoire de travail (17) du système de mesure supérieur (13), puis transcrites dans une mémoire de valeurs fixes (7) du dispositif de mesure (1).

5. Procédé selon l'une des revendications 3 ou 4, caractérisé par le fait que la zone de mesure est parcourue successivement dans les deux sens du déplacement, et que les valeurs correctives sont mémorisées et interrogées en fonction du sens de déplacement.

6. Circuit pour la mise en oeuvre du procédé selon l'une des revendications 3 à 5, comprenant un dispositif de mesure (1) prévu pour la zone de mesure, qui comprend une unité d'exploration prévue pour une échelle graduée qui s'étend sur la zone de mesure, ainsi qu'une unité d'analyse des signaux qui comprend elle-même un calculateur d'interpolation (5), un calculateur de valeurs de mesure (6) et un générateur de signaux (8) alimentant une unité d'affichage ou de commande (10), une mémoire de correction (7) étant associée au calculateur de valeurs de mesure (6) ; un système de mesure supérieur (13) destiné à la mesure de contrôle de la zone de mesure ; et un étage comparateur (15) destiné à déterminer des valeurs correctives mémorisables à partir des écarts entre la valeur de mesure instantanée du dispositif de mesure (1) et la valeur mesurée du système de mesure supérieur (13), caractérisé par le fait que l'étage comparateur est constitué par un comparateur de valeurs de mesure (15) réglé sur une valeur fixe, qui sélectionne, lors de l'exploitation de l'échelle graduée, en faisant intervenir un calculateur de correction (16), les adresses de la mémoire de correction (7) ou d'une mémoire de travail (17) du système de mesure supérieur (13) qui correspondent aux endroits de l'échelle graduée dans la région desquels la valeur de mesure instantanée du dispositif de mesure ou la valeur de mesure corrigée jusqu'à la correction qui s'est produite en dernier lieu s'écarte de la valeur de mesure du système de mesure supérieur (13) d'une valeur égale à la valeur fixe, cependant que, dans l'utilisation d'une mémoire de travail (17) dans le système de mesure supérieur (13), les adresses de correction peuvent être transcrites dans la mémoire de correction (7) du dispositif de mesure (1).